# EUROPÄISCHE PATENTSCHRIFT

(11) **EP 1 927 973 B1**
(45) Veröffentlichungstag und Bekanntmachung des Hinweises auf die Patenterteilung: **03.05.2017**
(21) Anmeldenummer: 07121530.5
(22) Anmeldetag: 26.11.2007
(51) Int. Cl.: H01L 27/32, G09G 3/32, H05B 33/08, H05B 37/03

(54) **Strukturanordnung und Verfahren zur Ausfallsicherung einer LED- oder OLED-Kette**
Structure assembly and method for outage protection of an LED or OLED chain
Ensemble de structure et procédé de protection contre les pannes d'une chaîne DEL ou OLED

(30) Priorität: 30.11.2006 WO PCT/EP2006/069097
(43) Veröffentlichungstag der Anmeldung: 04.06.2008
(73) Patentinhaber: OSRAM OLED GmbH, 93049 Regensburg (DE)
(72) Erfinder: Niedermeier, Peter, 80995 München (DE)
(74) Vertreter: Epping - Hermann - Fischer

(56) Entgegenhaltungen:
- EP-A- 1 396 676
- US-A- 4 233 543
- US-A- 5 886 423
- US-A1- 2006 220 585
- US-B1- 6 800 999

## Beschreibung

Diese Patentanmeldung beansprucht die Priorität der internationalen Patentanmeldung WO 2008/064717.

### Technisches Gebiet

Die vorliegende Erfindung betrifft eine Strukturanordnung zur Ausfallsicherung einer Kette aus in Serie geschalteten LED oder OLED Leuchtelementen, wobei bei der Herstellung des Leuchtelementes an geeigneter Stelle gezielt eine Schwachstelle in Form einer Durchbruchschicht eingebaut wird, die die normale Flussspannung des Leuchtelementes gut isolieren kann, aber bei einem Ausfall des Leuchtelements infolge der dann anliegenden hohen Spannung durchbricht und das ausgefallene Leuchtelement gezielt überbrückt.

### Stand der Technik

Heutzutage werden LED und OLED-Leuchtelemente für eine Vielzahl von Lichttechnischen Anwendungen wie z.B. in große Displays, Computerdisplays, Handydisplays, Signalleuchten bei Kfz etc. projektiert. Bei diesen Anwendungen müssen meistens eine Vielzahl von Leuchtelementen eingesetzt werden. Da OLEDs eine recht kleine Betriebsspannung haben, werden oftmals mehrere dieser Leuchtelemente in Serie geschaltet, um die Stromverteilung innerhalb der Anwendung zu verbessern.

Dabei tritt jedoch das Problem auf, dass bei einem Ausfall eines einzelnen Leuchtelementes die komplette Kette der in Serie geschalteten Leuchtelemente ausfällt, da der Stromkreis unterbrochen ist. Da die OLEDs oftmals gemeinsam auf ein Substrat aufgebracht sind, ist es unmöglich, die Funktionsfähigkeit der gesamten seriellen Kette wiederherzustellen. Der Ausfall eines einzigen Elementes würde allerdings bei der Vielzahl an verbauten Leuchtelementen nicht übermäßig auffallen.

Die Patentschrift US 6,800,999 B1 offenbart ein Licht emittierendes Bauelement, in dem organische Licht emittierende Dioden in Serie und parallel zu jeder Licht emittierenden Diode ein Schaltelement geschaltet ist.

Die Druckschrift US 2006/0220585 A1 betrifft in Serie geschaltete LEDs mit dazu geschalteten Shunts in Form von vierlagigen Halbleiterelementen.

Die Patentschrift US 5,886,423 betrifft eine elektrische Schaltung mit in Serie geschalteten Abnehmern und parallel geschalteten Umschaltelementen.

In der Patentschrift US 4,233,543 werden Shunts in in Serie geschalteten Glühbirnen offenbart.

### Darstellung der Erfindung

Die Aufgabe der vorliegenden Erfindung besteht deshalb darin, eine Struktur anzugeben, mit der bei einem Ausfall mindestens eines Leuchtelementes die Funktionsfähigkeit der in der Kette verbliebenen Leuchtelemente gewährleistet wird.

Diese Aufgabe wird gelöst durch eine strukturelle Anordnung mit den Merkmalen von Patentanspruch 1 sowie durch ein Verfahren mit den Merkmalen von Patentanspruch 6. Die vorliegende Erfindung basiert auf der Erkenntnis, dass die obige Aufgabe gelöst werden kann, wenn in die bekannten LED- oder OLED-Strukturen eine dünne Durchbruchschicht, beispielsweise eine Oxidschicht, mit einer über der Durchbruchschicht angelegten Brücke integriert wird.

Die Durchbruchschicht wird auf stromzuführende Strukturen aufgebracht, und bricht bei Ausfall eines Leuchtelementes aufgrund der dann hohen auftretenden Spannung durch, somit werden die darüber liegende leitende Schicht und die stromzuführende Struktur (z.B. das darunter liegende Kathodenmaterial) leitend verbunden, die so den Stromkreis wieder schließen, und somit die ausgefallene LED oder OLED überbrücken, wobei zwei Kathodenschichten leitend miteinander verbunden werden.

Die Durchbruchschicht kann elektrisch isolierend sein und beispielsweise eine Oxidschicht umfassen. Die Oxidschicht kann eine dünne Oxidschicht sein.

Die erfindungsgemäße Anordnung kann auf einfache Weise in den Herstellungsprozess einer LED oder OLED integriert werden, so dass für die Applikation keine weiteren Bauteile und somit keine weiteren Kosten anfallen.

Dadurch, dass die Dicke der Durchbruchschicht in einem Bereich liegt, der bei einem Mehrfachen der OLED-Flussspannung sicher durchbricht, ist eine hohe Ausfallsicherheit gewährleistet.

Dadurch, dass die Durchbruchschicht bei der doppelten OLED-Flussspannung noch sicher isoliert, ist eine hohe Sicherheit gegen unerwünschtes Überbrücken eines noch Funktionierenden OLED-Leuchtelementes gewährleistet.

### Kurze Beschreibung der Zeichnung

Im Nachfolgenden werden nunmehr Ausführungsbeispiele einer erfindungsgemäßen Schaltungsanordnung unter Bezugnahme auf die beigefügte Zeichnung näher beschrieben. Es zeigt:

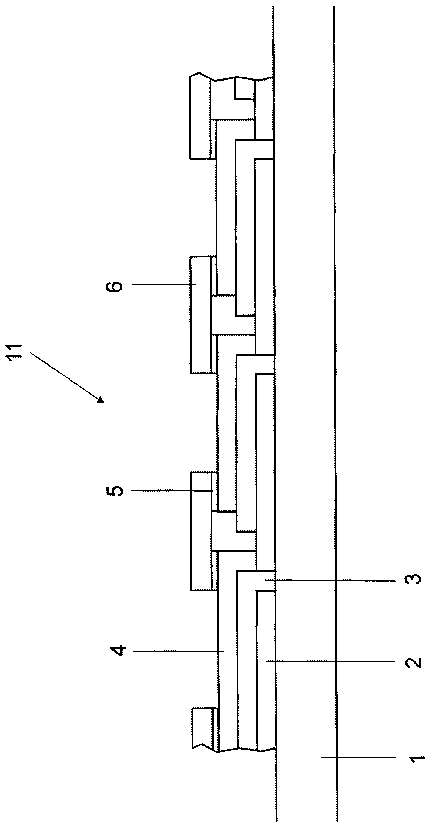

- Fig. 1: Den strukturellen Aufbau der erfindungsgemäßen OLED Strukturanordnung.

Fig. 1 zeigt in schematischer Darstellung den Aufbau der erfindungsgemäßen Anordnung. Auf ein Trägersubstrat (1), das aus Glas, geeigneten Folien oder ähnlichem bestehen kann, sind mehrere Schichten (2-4) aufgebracht. Die unterste Schicht ist die Anodenschicht (2), und besteht aus einer leitenden Schicht, z.B. aus einer ITO-Schicht (Indium Tin Oxide). Auf die Anode wird eine oder mehrere Schichten organischen Materials (3) aufgebracht. Sie bilden die eigentliche Leuchtschicht, die das Licht emittiert. Auf diese Schicht wird dann das Kathodenmaterial (4) aufgebracht. Bis hierher entspricht der Aufbau dem einer OLED nach dem Stand der Technik. Bei vielen Anwendungen sind die Strukturen so angeordnet, dass eine Vielzahl von in Serie geschalteten OLED-Leuchtelementen entsteht. Bei einer herkömmlichen OLED-Kette besteht nun der Nachteil, dass ein Ausfall eines dieser Leuchtelemente die ganze Kette der Leuchtelemente ohne Strom und somit funktionsuntüchtig macht.

In erfinderischer Weise wird nun auf das Kathodenmaterial eine Durchbruchschicht (5), aufgebracht. Über diese Durchbruchschicht wird wiederum eine leitende Schicht (6) gelegt, die die Brücke zwischen den Bauteilen bildet. Die Durchbruchschicht kann elektrisch isolierend sein und beispielsweise eine Oxidschicht umfassen.

Fällt nun ein OLED-Leuchtelement (11) aus, so ist der Stromkreis offen, und zwischen der Kathode des ausgefallenen OLED-Leuchtelements und der Kathode eines benachbarten OLED-Leuchtelements liegt eine Spannung an, die auf jeden Fall größer als die Summe der Flussspannungen aller OLED-Leuchtelemente in der Kette ist. Dass heißt, diese Spannung liegt ebenfalls zwischen den entsprechenden Kathodenschichten und der leitenden Brückenschicht, also an der Durchbruchschicht an. Diese hohe Spannung kann aber die Durchbruchschicht nicht isolieren, daher bricht sie durch, und verbindet die beiden benachbarten Kathodenschichten leitend miteinander. Damit ist das defekte OLED-Leuchtelement überbrückt und der Stromkreis wieder geschlossen, so dass die verbliebenen OLED-Leuchtelemente normal arbeiten können.

Die Schicht ist bevorzugt so dünn ausgeführt, dass sie bei einem mehrfachen der OLED-Flussspannung sicher durchbricht. Wenn eine OLED ausfällt und den Stromkreis unterbricht, liegt an ihr die gesamte Strangspannung an. Diese beträgt in etwa die Flussspannung der OLEDs mal deren Anzahl. Da in einer solchen Kette normalerweise mindestens eine Anzahl im hohen einstelligen Bereich verbaut ist, beträgt die anliegende Spannung ein Vielfaches der OLED-Flussspannung, und die defekte Diode kann sicher überbrückt werden.

Die Schicht ist aber auch bevorzugt so dick ausgeführt, dass sie mindestens der einfachen, besser der doppelten Flussspannung sicher standhält. Dies vermeidet den unerwünschten Effekt, dass bei kurzen Spannungsspitzen oder Störungen in der Spannungsversorgung die Schicht ungewollt durchbricht und ein noch funktionsfähiges OLED-Leuchtelement überbrückt und somit abschaltet.

In ähnlicher Form kann auch mit einer Kettenschaltung von LED-Leuchtelementen verfahren werden. Da LED-Leuchtelemente meistens als Einzelchips aufgebaut werden, und die obenliegende Anode mit einem Bonddraht versehen ist, wäre hier eine Überbrückung von Kathode zu Kathode denkbar. Ebenso ist eine an sich bekannte Methode aus der Christbaumbeleuchtung denkbar, nämlich ein mit einer Durchbruchschicht, beispielsweise einer Oxidschicht versehener Draht, der um die Anschlussbeinchen einer bedrahteten Leuchtdiode gewickelt ist. Bei einer SMD-Leuchtdiode könnte die Brücke auf der Unterseite zwischen den Anschlussblechen angebracht werden.

## Patentansprüche

1. Strukturelle Anordnung zur Ausfallsicherung einer LED- oder OLED-Kette mit mehreren in Serie geschalteten LED oder OLED-Leuchtelementen (11), wobei jedes LED- oder OLED-Leuchtelement eine Kathodenschicht (4) aufweist, **dadurch gekennzeichnet, dass**
bei Herstellung des Leuchtelements an mindestens einer Stelle der Struktur zwischen zwei Stromzuführungen zweier benachbarter Leuchtelemente gezielt eine Schwachstelle in Form einer Durchbruchschicht (5) eingebaut wird, die im Falle des Ausfalls des Leuchtelementes durchbricht und dieses mittels einer leitenden Brückenschicht (6) überbrückt, so dass die Brückenschicht (6) die Kathodenschicht des ausgefallenen Leuchtelements mit der Kathodenschicht eines benachbarten Leuchtelement leitend verbindet.

2. Strukturelle Anordnung zur Ausfallsicherung einer LED- oder OLED-Kette mit mehreren in Serie geschalteten LED- oder OLED-Leuchtelementen (11) nach Anspruch 1, wobei die Durchbruchschicht (5) elektrisch isolierend ist.

3. Strukturelle Anordnung zur Ausfallsicherung einer LED- oder OLED-Kette mit mehreren in Serie geschalteten LED- oder OLED-Leuchtelementen (11) nach Anspruch 1 oder 2, **dadurch gekennzeichnet, dass**
die Dicke der Durchbruchschicht (5) so bemessen ist, dass sie mindestens eine Spannung in Höhe der Flussspannung des LED- oder OLED-Leuchtelements sicher isolieren kann.

4. Strukturelle Anordnung zur Ausfallsicherung einer LED- oder OLED-Kette mit mehreren in Serie geschalteten OLED-Leuchtelementen (11) nach einem der Ansprüche 1 bis 3, **dadurch gekennzeichnet, dass**
die Dicke der Durchbruchschicht (5) so bemessen ist, dass sie bei einer Spannung, die einem mehrfachen der Flussspannung des LED- oder OLED-Leuchtelements entspricht, sicher durchbricht.

5. Strukturelle Anordnung zur Ausfallsicherung einer LED- oder OLED-Kette mit mehreren in Serie geschalteten LED- oder OLED-Leuchtelementen (11) nach einem der Ansprüche 1 bis 4, wobei die Durchbruchschicht (5) eine Oxidschicht umfasst.

6. Verfahren zur Ausfallsicherung einer LED- oder OLED-Kette mit mehreren in Serie geschalteten LED- oder OLED-Leuchtelementen (11), **gekennzeichnet durch** folgende Schritte:
a) Herstellen einer herkömmlichen LED- oder OLED-Kette, wobei jedes LED- oder OLED Element eine Kathodenschicht (4) aufweist
b) Aufbringen einer Durchbruchschicht (5) auf die Kathodenschicht (4)
c) Aufbringen einer leitenden Brückenschicht (6) auf die Durchbruchschicht.

7. Verfahren nach dem vorhergehenden Anspruch, wobei die Durchbruchschicht (5) elektrisch isolierend ist.

8. Verfahren nach einem der Ansprüche 6 oder 7, wobei die Durchbruchschicht (5) eine Oxidschicht umfasst.

## Claims

1. Structural arrangement for failure protection of an LED or OLED chain with a plurality of series-connected LED or OLED light-emitting elements (11), each LED or OLED light-emitting element comprising a cathode layer (4), **characterized in that**
on production of the light-emitting element, at at least one point of the structure between two current feeders of two adjacent light-emitting elements a weak point is purposefully installed in the form of a breakdown layer (5), which breaks down in the case of failure of the light-emitting element and bridges the latter by means of a conductive bridging layer (6), such that the bridging layer (6) conductively connects the cathode layer of the failed light-emitting element to the cathode layer of an adjacent light-emitting element.

2. Structural arrangement for failure protection of an LED or OLED chain with a plurality of series-connected LED or OLED light-emitting elements (11) according to claim 1, wherein the breakdown layer (5) is electrically insulating.

3. Structural arrangement for failure protection of an LED or OLED chain with a plurality of series-connected LED or OLED light-emitting elements (11) according to claim 1 or 2, **characterized in that**
the thickness of the breakdown layer (5) is such that it can reliably insulate at least one voltage of the order of the forward voltage of the LED or OLED light-emitting element.

4. Structural arrangement for failure protection of an LED or OLED chain with a plurality of series-connected OLED light-emitting elements (11) according to one of claims 1 to 3, **characterized in that**
the thickness of the breakdown layer (5) is such that it reliably breaks down in the event of a voltage which corresponds to a multiple of the forward voltage of the LED or OLED light-emitting element.

5. Structural arrangement for failure protection of an LED or OLED chain with a plurality of series-connected LED or OLED light-emitting elements (11) according to one of claims 1 to 4, wherein the breakdown layer (5) comprises an oxide layer.

6. Method for failure protection of an LED or OLED chain with a plurality of series-connected LED or OLED light-emitting elements (11), **characterized by** the following steps:
a) producing a conventional LED or OLED chain, wherein each LED or OLED element comprises a cathode layer (4)
b) applying a breakdown layer (5) to the cathode layer (4)
c) applying a conductive bridging layer (6) to the breakdown layer.

7. Method according to the preceding claim, wherein the breakdown layer (5) is electrically insulating.

8. Method according to one of claims 6 or 7, wherein the breakdown layer (5) comprises an oxide layer.

## Revendications

1. Agencement structurel pour la sécurité anti-défaillance d'une chaîne de LED ou OLED comprenant plusieurs éléments lumineux (11) à LED ou OLED connectés en série, chaque élément lumineux à LED ou OLED présentant une couche cathodique (4),
**caractérisé en ce que**
lors de la fabrication de l'élément lumineux, un point faible est inséré de manière ciblée sous forme d'une couche de rupture (5) à au moins un endroit de la structure situé entre deux alimentations de courant de deux éléments lumineux adjacents, laquelle couche de rupture se rompt en cas de défaillance de l'élément lumineux et court-circuite celui-ci au moyen d'une couche de pont (6) conductrice, de sorte que la couche de pont (6) relie de manière conductrice la couche cathodique de l'élément lumineux défaillant à la couche cathodique d'un élément lumineux adjacent.

2. Agencement structurel pour la sécurité anti-défaillance d'une chaîne de LED ou OLED comprenant plusieurs éléments lumineux (11) à LED ou OLED connectés en série selon la revendication 1, la couche de rupture (5) étant électriquement isolante.

3. Agencement structurel pour la sécurité anti-défaillance d'une chaîne de LED ou OLED comprenant plusieurs éléments lumineux (11) à LED ou OLED connectés en série selon la revendication 1 ou 2, **caractérisé en ce que** l'épaisseur de la couche de rupture (5) est dimensionnée de façon à ce qu'elle puisse isoler de manière fiable au moins une tension à hauteur de la tension de flux de l'élément lumineux à LED ou OLED.

4. Agencement structurel pour la sécurité anti-défaillance d'une chaîne de LED ou OLED comprenant plusieurs éléments lumineux (11) à LED ou OLED connectés en série selon l'une quelconque des revendications 1 à 3, **caractérisé en ce que**
l'épaisseur de la couche de rupture (5) est dimensionnée de façon à ce,
qu'en cas d'une tension correspondant à un multiple de la tension de flux de l'élément lumineux à LED ou OLED, elle se rompe de manière fiable.

5. Agencement structurel pour la sécurité anti-défaillance d'une chaîne de LED ou OLED comprenant plusieurs éléments lumineux (11) à LED ou OLED connectés en série selon l'une quelconque des revendications 1 à 4, la couche de rupture (5) comprenant une couche d'oxyde.

6. Procédé destiné à la sécurité anti-défaillance d'une chaîne de LED ou OLED comprenant plusieurs éléments lumineux (11) à LED ou OLED connectés en série, **caractérisé par** les étapes suivantes :
a) Fabrication d'une chaîne de LED ou OLED conventionnelle, chaque élément à LED ou OLED présentant une couche cathodique (4)
b) Application d'une couche de rupture (5) sur la couche cathodique (4)
c) Application d'une couche de pont (6) conductrice sur la couche de rupture.

7. Procédé selon la revendication précédente, la couche de rupture (5) étant électriquement isolante.

8. Procédé selon l'une quelconque des revendications 6 ou 7, la couche de rupture (5) comprenant une couche d'oxyde.
